# EUROPEAN PATENT APPLICATION

(11) **EP 4 530 717 A1**
(43) Date of publication of application: **02.04.2025**
(21) Application number: 23199669.5
(22) Date of filing: 26.09.2023
(51) Int. Cl.: G03F 7/00, G03F 9/00, G02B 27/10, G02B 5/18, G02B 26/08

(54) **A METHOD OF SPECTRALLY CONFIGURING MEASUREMENT ILLUMINATION OF A METROLOGY TOOL AND ASSOCIATED APPARATUSES**

(71) Applicant: ASML Netherlands B.V., 5500 AH Veldhoven (NL)
(72) Inventor: VAN GREEVENBROEK, Hendrikus, Robertus, Marie, 5500 AH Veldhoven (NL); KUZUCU, Oktay, Onur, 5500 AH Veldhoven (NL)
(74) Representative: ASML Netherlands B.V.

(57) **Abstract**

Disclosed is a method of spectrally configuring measurement illumination of a metrology tool, the method comprising: projecting measurement radiation using a projection optical system to obtain projected measurement radiation; measuring a signal amplitude metric of said projected measurement radiation at a detector; determining a spectral shape of the projected measurement radiation from the signal amplitude metric; and spectrally configuring the measurement illumination before the projection optical system to adjust said spectral shape to match a desired spectral shape.

## Description

### FIELD OF THE INVENTION

The present invention relates to methods of manufacture of devices by lithographic techniques.

### BACKGROUND

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g., including part of, one, or several dies) on a substrate (e.g., a silicon wafer). Transfer of the pattern is typically via imaging onto a layer of radiation-sensitive material (resist) provided on the substrate. In general, a single substrate will contain a network of adjacent target portions that are successively patterned. In lithographic processes, it is desirable frequently to make measurements of the structures created, e.g., for process control and verification. Various tools for making such measurements are known, including scanning electron microscopes, which are often used to measure critical dimension (CD), and specialized tools to measure overlay, a measure of the accuracy of alignment of two layers in a device. Overlay may be described in terms of the degree of misalignment between the two layers, for example reference to a measured overlay of 1nm may describe a situation where two layers are misaligned by 1nm.

Recently, various forms of scatterometers have been developed for use in the lithographic field. These devices direct a beam of radiation onto a target and measure one or more properties of the scattered radiation - e.g., intensity at a single angle of reflection as a function of wavelength; intensity at one or more wavelengths as a function of reflected angle; or polarization as a function of reflected angle - to obtain a "spectrum" from which a property of interest of the target can be determined. Determination of the property of interest may be performed by various techniques: e.g., reconstruction of the target by iterative approaches such as rigorous coupled wave analysis or finite element methods; library searches; and principal component analysis.

The targets used by conventional scatterometers are relatively large, e.g., 40µm by 40µm, gratings and the measurement beam generates a spot that is smaller than the grating (i.e., the grating is underfilled). This simplifies mathematical reconstruction of the target as it can be regarded as infinite. However, in order to reduce the size of the targets, e.g., to 10µm by 10µm or less, e.g., so they can be positioned in amongst product features, rather than in the scribe lane, metrology has been proposed in which the grating is made smaller than the measurement spot (i.e., the grating is overfilled). Typically such targets are measured using dark field scatterometry in which the zeroth order of diffraction (corresponding to a specular reflection) is blocked, and only higher orders processed. Examples of dark field metrology can be found in international patent applications WO 2009/078708 and WO 2009/106279 which documents are hereby incorporated by reference in their entirety. Further developments of the technique have been described in patent publications US20110027704A, US20110043791A and US20120242940A. The contents of all these applications are also incorporated herein by reference. Diffraction-based overlay using dark-field detection of the diffraction orders enables overlay measurements on smaller targets. These targets can be smaller than the illumination spot and may be surrounded by product structures on a wafer. Targets can comprise multiple gratings which can be measured in one image.

The projection optical systems of different metrology tools typically have different spectral transmission characteristics resulting in different spectra at wafer level for the same illumination setting. The illumination setting may be set, for example, using a color selection module or illumination configuration module to spectrally configure broadband source illumination for the metrology tool.

As a result of imperfections in structures (e.g., metrology targets, alignment marks or product structures) being measured, there may be a wavelength dependent variation in a measured signal from the target. To address this, each structure may be measured (e.g., one or more times) with spectrally configured radiation. However, any unknown tool-to-tool spectral variation in the measurement illumination will result in unknown tool-to-tool measurement variation.

It is desirable to mitigate for the effect of different spectral transmission characteristics of the different metrology tools on measurements performed using the tools.

### SUMMARY

In a first aspect of the invention there is provided a method of spectrally configuring measurement illumination of a metrology tool, the method comprising: projecting measurement radiation using said projection optical system to obtain projected measurement radiation; measuring a signal amplitude metric of said projected measurement radiation at a detector; determining a spectral shape of the projected measurement radiation from the signal amplitude metric; and spectrally configuring the measurement illumination before the projection optical system to adjust said spectral shape to match a desired spectral shape.

Another aspect of the invention comprises at least one metrology device operable to perform the method of the first aspect.

Further features and advantages of the invention, as well as the structure and operation of various embodiments of the invention, are described in detail below with reference to the accompanying drawings. It is noted that the invention is not limited to the specific embodiments described herein. Such embodiments are presented herein for illustrative purposes only. Additional embodiments will be apparent to persons skilled in the relevant art(s) based on the teachings contained herein.

### BRIEF DESCRIPTION OF THE DRAWINGS

Embodiments of the invention will now be described, by way of example only, with reference to the accompanying drawings in which:
Figure 1 depicts a lithographic apparatus according to an embodiment of the invention;
Figure 2 depicts a lithographic cell or cluster according to an embodiment of the invention;
Figure 3(a) comprises a schematic diagram of a dark field scatterometer for use in measuring targets according to embodiments of the invention using a first pair of illumination apertures; Figure 3(b) illustrates a detail of diffraction spectrum of a target grating for a given direction of illumination; Figure 3(c) illustrates a second pair of illumination apertures providing further illumination modes in using the scatterometer for diffraction based overlay measurements; and Figure 3(d) illustrates a third pair of illumination apertures combining the first and second pair of apertures;
Figures 4(a), 4(b) and 4(c) depict schematically a grating light valve (GLV), illustrating its basic operation in (a) a top view, (b) an end-on view in a first configuration and (c) an end-on view in a second configuration;
Figures 5(a) and 5(b) depict schematically, respectively a top view and side view of a GLV based illumination configuration module;
Figure 6 is a high-level module diagram of a metrology tool;

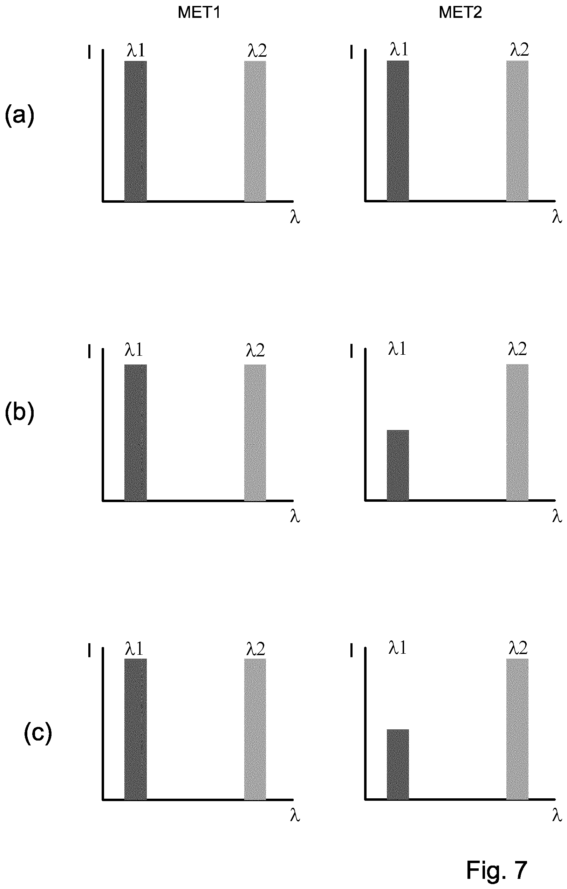

Figures 7(a)-7(c) illustrates an issue resulting from different spectral transmission characteristics of different illumination tool: Figure 7(a) comprises a plot of intensity against wavelength as set by an illumination configuration module for each of two metrology tools, Figure 7(b) comprises a plot of intensity against wavelength illustrating the spectral transmission characteristics of each of the two illumination tools, and Figure 7(c) comprises a plot of intensity against wavelength illustrating the resultant spectral characteristics of the measurement illumination at wafer level for each of the two metrology tools; and
Figure 8(a), Figure 8(b) and Figure 8(c) are equivalent plots to those of Figure 7(a), Figure 7(b) and Figure 7(c), but where a method according to an embodiment has been employed, e.g., using the illumination configuration module.

### DETAILED DESCRIPTION OF EXEMPLARY EMBODIMENTS

Before describing embodiments of the invention in detail, it is instructive to present an example environment in which embodiments of the present invention may be implemented.

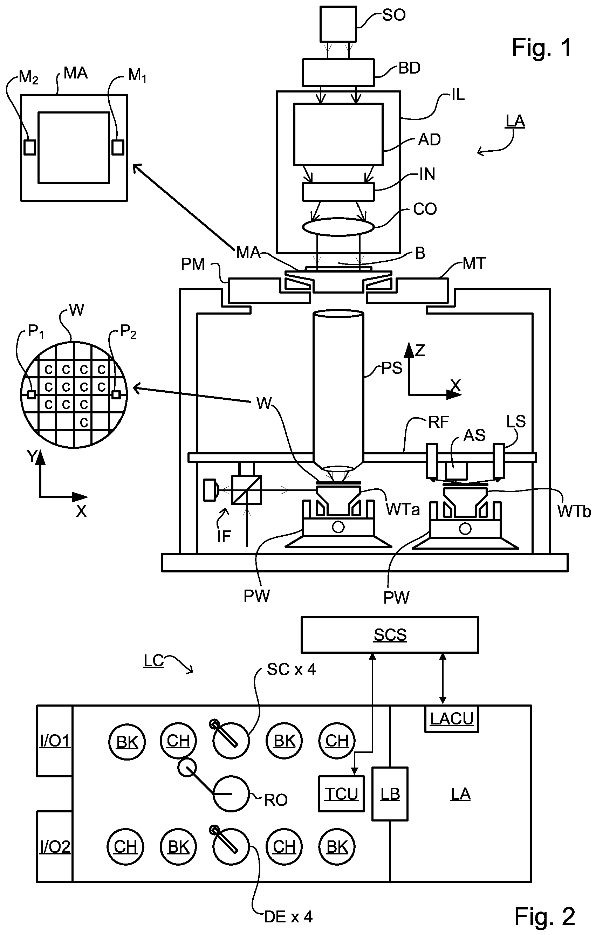

Figure 1 schematically depicts a lithographic apparatus LA. The apparatus includes an illumination optical system (illuminator) IL configured to condition a radiation beam B (e.g., UV radiation or DUV radiation), a patterning device support or support structure (e.g., a mask table) MT constructed to support a patterning device (e.g., a mask) MA and connected to a first positioner PM configured to accurately position the patterning device in accordance with certain parameters; a substrate table (e.g., a wafer table) WT constructed to hold a substrate (e.g., a resist coated wafer) W and connected to a second positioner PW configured to accurately position the substrate in accordance with certain parameters; and a projection optical system (e.g., a refractive projection lens system) PS configured to project a pattern imparted to the radiation beam B by patterning device MA onto a target portion C (e.g., including one or more dies) of the substrate W.

The illumination optical system may include various types of optical components, such as refractive, reflective, magnetic, electromagnetic, electrostatic or other types of optical components, or any combination thereof, for directing, shaping, or controlling radiation.

The patterning device support holds the patterning device in a manner that depends on the orientation of the patterning device, the design of the lithographic apparatus, and other conditions, such as for example whether or not the patterning device is held in a vacuum environment. The patterning device support can use mechanical, vacuum, electrostatic or other clamping techniques to hold the patterning device. The patterning device support may be a frame or a table, for example, which may be fixed or movable as required. The patterning device support may ensure that the patterning device is at a desired position, for example with respect to the projection system. Any use of the terms "reticle" or "mask" herein may be considered synonymous with the more general term "patterning device."

The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

The patterning device may be transmissive or reflective. Examples of patterning devices include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions. The tilted mirrors impart a pattern in a radiation beam, which is reflected by the mirror matrix.

As here depicted, the apparatus is of a transmissive type (e.g., employing a transmissive mask). Alternatively, the apparatus may be of a reflective type (e.g., employing a programmable mirror array of a type as referred to above, or employing a reflective mask).

The lithographic apparatus may also be of a type wherein at least a portion of the substrate may be covered by a liquid having a relatively high refractive index, e.g., water, so as to fill a space between the projection system and the substrate. An immersion liquid may also be applied to other spaces in the lithographic apparatus, for example, between the mask and the projection system. Immersion techniques are well known in the art for increasing the numerical aperture of projection systems. The term "immersion" as used herein does not mean that a structure, such as a substrate, must be submerged in liquid, but rather only means that liquid is located between the projection system and the substrate during exposure.

Referring to Figure 1, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD including, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

The illuminator IL may include an adjuster AD for adjusting the angular intensity distribution of the radiation beam. Generally, at least the outer and/or inner radial extent (commonly referred to as σ-outer and σ-inner, respectively) of the intensity distribution in a pupil plane of the illuminator can be adjusted. In addition, the illuminator IL may include various other components, such as an integrator IN and a condenser CO. The illuminator may be used to condition the radiation beam, to have a desired uniformity and intensity distribution in its cross section.

The radiation beam B is incident on the patterning device (e.g., mask) MA, which is held on the patterning device support (e.g., mask table MT), and is patterned by the patterning device. Having traversed the patterning device (e.g., mask) MA, the radiation beam B passes through the projection optical system PS, which focuses the beam onto a target portion C of the substrate W, thereby projecting an image of the pattern on the target portion C. With the aid of the second positioner PW and position sensor IF (e.g., an interferometric device, linear encoder, 2-D encoder or capacitive sensor), the substrate table WT can be moved accurately, e.g., so as to position different target portions C in the path of the radiation beam B. Similarly, the first positioner PM and another position sensor (which is not explicitly depicted in Figure 1) can be used to accurately position the patterning device (e.g., mask) MA with respect to the path of the radiation beam B, e.g., after mechanical retrieval from a mask library, or during a scan.

Patterning device (e.g., mask) MA and substrate W may be aligned using mask alignment marks M1, M2 and substrate alignment marks P1, P2. Although the substrate alignment marks as illustrated occupy dedicated target portions, they may be located in spaces between target portions (these are known as scribe-lane alignment marks). Similarly, in situations in which more than one die is provided on the patterning device (e.g., mask) MA, the mask alignment marks may be located between the dies. Small alignment markers may also be included within dies, in amongst the device features, in which case it is desirable that the markers be as small as possible and not require any different imaging or process conditions than adjacent features. The alignment system, which detects the alignment markers is described further below.

Lithographic apparatus LA in this example is of a so-called dual stage type which has two substrate tables WTa, WTb and two stations - an exposure station and a measurement station - between which the substrate tables can be exchanged. While one substrate on one substrate table is being exposed at the exposure station, another substrate can be loaded onto the other substrate table at the measurement station and various preparatory steps carried out. The preparatory steps may include mapping the surface control of the substrate using a level sensor LS and measuring the position of alignment markers on the substrate using an alignment sensor AS. This enables a substantial increase in the throughput of the apparatus.

The depicted apparatus can be used in a variety of modes, including for example a step mode or a scan mode. The construction and operation of lithographic apparatus is well known to those skilled in the art and need not be described further for an understanding of the present invention.

As shown in Figure 2, the lithographic apparatus LA forms part of a lithographic system, referred to as a lithographic cell LC or a lithocell or cluster. The lithographic cell LC may also include apparatus to perform pre- and post-exposure processes on a substrate. Conventionally these include spin coaters SC to deposit resist layers, developers DE to develop exposed resist, chill plates CH and bake plates BK. A substrate handler, or robot, RO picks up substrates from input/output ports I/O1, I/O2, moves them between the different process apparatus and delivers then to the loading bay LB of the lithographic apparatus. These devices, which are often collectively referred to as the track, are under the control of a track control unit TCU which is itself controlled by the supervisory control system SCS, which also controls the lithographic apparatus via lithography control unit LACU. Thus, the different apparatus can be operated to maximize throughput and processing efficiency.

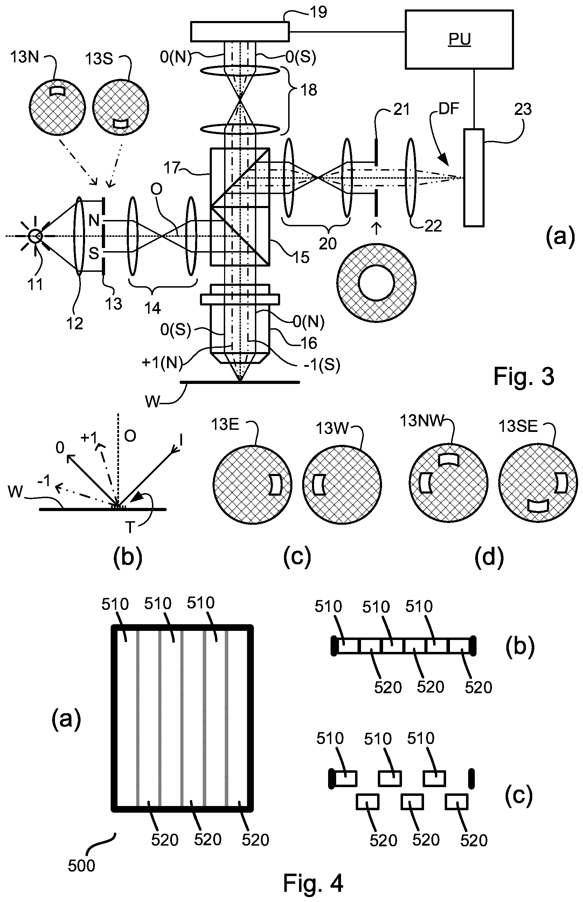

A metrology apparatus suitable for use in embodiments of the invention is shown in Figure 3(a). A target T and diffracted rays of measurement radiation used to illuminate the target are illustrated in more detail in Figure 3(b). The metrology apparatus illustrated is of a type known as a dark field metrology apparatus. The metrology apparatus may be a stand-alone device or incorporated in either the lithographic apparatus LA, e.g., at the measurement station, or the lithographic cell LC. An optical axis, which has several branches throughout the apparatus, is represented by a dotted line O. In this apparatus, light emitted by source 11 (e.g., a xenon lamp) is directed onto substrate W via a beam splitter 15 by an optical system comprising lenses 12, 14 and objective lens 16. These lenses are arranged in a double sequence of a 4F arrangement. A different lens arrangement can be used, provided that it still provides a substrate image onto a detector, and simultaneously allows for access of an intermediate pupil-plane for spatial-frequency filtering. Therefore, the angular range at which the radiation is incident on the substrate can be selected by defining a spatial intensity distribution in a plane that presents the spatial spectrum of the substrate plane, here referred to as a (conjugate) pupil plane. In particular, this can be done by inserting an aperture plate 13 of suitable form between lenses 12 and 14, in a plane which is a back-projected image of the objective lens pupil plane. In the example illustrated, aperture plate 13 has different forms, labeled 13N and 13S, allowing different illumination modes to be selected. The illumination system in the present examples forms an off-axis illumination mode. In the first illumination mode, aperture plate 13N provides off-axis from a direction designated, for the sake of description only, as 'north'. In a second illumination mode, aperture plate 13S is used to provide similar illumination, but from an opposite direction, labeled 'south'. Other modes of illumination are possible by using different apertures, such as those which enable simultaneous illumination and detection from two opposing directions in combination with optical wedges to separate the resultant images. The rest of the pupil plane is desirably dark as any unnecessary light outside the desired illumination mode will interfere with the desired measurement signals.

As shown in Figure 3(b), target T is placed with substrate W normal to the optical axis O of objective lens 16. The substrate W may be supported by a support (not shown). A ray of measurement radiation I impinging on target T from an angle off the axis O gives rise to a zeroth order ray (solid line 0) and two first order rays (dot-chain line +1 and double dot-chain line -1). It should be remembered that with an overfilled small target, these rays are just one of many parallel rays covering the area of the substrate including metrology target T and other features. Since the aperture in plate 13 has a finite width (necessary to admit a useful quantity of light, the incident rays I will in fact occupy a range of angles, and the diffracted rays 0 and +1/-1 will be spread out somewhat. According to the point spread function of a small target, each order +1 and -1 will be further spread over a range of angles, not a single ideal ray as shown. Note that the grating pitches of the targets and the illumination angles can be designed or adjusted so that the first order rays entering the objective lens are closely aligned with the central optical axis. The rays illustrated in Figure 3(a) and 3(b) are shown somewhat off axis, purely to enable them to be more easily distinguished in the diagram.

At least the 0 and +1 orders diffracted by the target T on substrate W are collected by objective lens 16 and directed back through beam splitter 15. Returning to Figure 3(a), both the first and second illumination modes are illustrated, by designating diametrically opposite apertures labeled as north (N) and south (S). When the incident ray I of measurement radiation is from the north side of the optical axis, that is when the first illumination mode is applied using aperture plate 13N, the +1 diffracted rays, which are labeled +1(N), enter the objective lens 16. In contrast, when the second illumination mode is applied using aperture plate 13S the -1 diffracted rays (labeled -1(S)) are the ones which enter the lens 16.

A second beam splitter 17 divides the diffracted beams into two measurement branches. In a first measurement branch, optical system 18 forms a diffraction spectrum (pupil plane image) of the target on first sensor 19 (e.g. a CCD or CMOS sensor) using the zeroth and first order diffractive beams. Each diffraction order hits a different point on the sensor, so that image processing can compare and contrast orders. The pupil plane image captured by sensor 19 can be used for focusing the metrology apparatus and/or normalizing intensity measurements of the first order beam. The pupil plane image can also be used for many measurement purposes such as reconstruction.

In the second measurement branch, optical system 20, 22 forms an image of the target T on sensor 23 (e.g. a CCD or CMOS sensor). In the second measurement branch, an aperture stop 21 is provided in a plane that is conjugate to the pupil-plane. Aperture stop 21 functions to block the zeroth order diffracted beam so that the image of the target formed on sensor 23 is formed only from the -1 or +1 first order beam. The images captured by sensors 19 and 23 are output to processor PU which processes the image, the function of which will depend on the particular type of measurements being performed. Note that the term 'image' is used here in a broad sense. An image of the grating lines as such will not be formed, if only one of the -1 and +1 orders is present.

The particular forms of aperture plate 13 and field stop 21 shown in Figure 3 are purely examples. In another embodiment of the invention, on-axis illumination of the targets is used and an aperture stop with an off-axis aperture is used to pass substantially only one first order of diffracted light to the sensor. In yet other embodiments, 2nd, 3rd and higher order beams (not shown in Figure 3) can be used in measurements, instead of or in addition to the first order beams.

In order to make the measurement radiation adaptable to these different types of measurement, the aperture plate 13 may comprise a number of aperture patterns formed around a disc, which rotates to bring a desired pattern into place. Note that aperture plate 13N or 13S can only be used to measure gratings oriented in one direction (X or Y depending on the set-up). For measurement of an orthogonal grating, rotation of the target through 90° and 270° might be implemented. Different aperture plates are shown in Figures 3(c) and (d). The use of these, and numerous other variations and applications of the apparatus are described in prior published applications, mentioned above.

It is known to use an apparatus such as illustrated in Figure 3(a) to measure overlay. To achieve this, overlay targets may be printed on a wafer in two layers. One method of overlay metrology (sometimes referred to as micro-diffraction based overlay (µDBO) infers overlay from an asymmetry imbalance in complementary diffraction orders from targets comprising a respective grating in each layer. Typically, in µDBO the gratings have the same single pitch in each layer, though there may be an imposed bias between the two targets.

Metrology tools MT, such as a scatterometer, topography measurement system, or position measurement system mentioned above may use radiation originating from a radiation source to perform a measurement. The properties of the radiation used by a metrology tool may affect the type and quality of measurements that may be performed. For some applications, it may be advantageous to use multiple radiation frequencies and/or polarization states to measure a substrate, for example broadband radiation may be used. Multiple different frequencies may be able to propagate, irradiate, and scatter off a metrology target with no or minimal interference with other frequencies. Therefore different frequencies may for example be used to obtain more metrology data simultaneously. Different radiation frequencies may also be able to interrogate and discover different properties of a metrology target. Broadband radiation may be useful in metrology systems MT such as for example level sensors, alignment mark measurement systems, scatterometry tools, or inspection tools. A broadband radiation source may be a supercontinuum source.

In many metrology applications, such as scatterometry or interferometry based metrology applications, e.g., for performance of pre-exposure metrology (such as alignment) or post-exposure metrology (e.g., overlay, CD, focus or other parameter of interest metrology), different information can be obtained from measurement of the same structure depending on the wavelength and polarization state of the measurement illumination used. For example, some present metrology systems provide measurement illumination configurable over multiple colors and three polarization settings (Horizontal, Vertical and both). However, the presently used illumination configuration modules (color switching modules) in such systems tend to be based on bulky mechanical modules which are slow. Additionally, such modules provide only three options when selecting the polarization of the incident beam: all wavelengths at a first polarization state (e.g., horizontal H), all wavelengths at a second polarization state (e.g., vertical V) or all wavelengths at both of these polarizations. It is very possible that any one polarization choice is suboptimal at some wavelengths. To measure each wavelength at its optimum polarization would require twice as many measurements as a single polarization measurement, with a slow polarization switch halfway through. Furthermore, arbitrary combinations of different polarization states are simply not presently possible.

A fast illumination configuration module or color switching module has been described, based on the grating light valve (GLV) concept. A GLV module disperses light (having been dispersed onto the GLV) such that the module can selectively remove or modulate light at one or more specific wavelengths. The resulting spectrum can be configured to comprise any desired shape, and can be varied at very high frequencies, possibly up to the MHz range. Such engineered spectra are a fast (microsecond switchable) way to extract a large amount of information from a target. However the known literature on GLV based illumination configuration describes only color selection, without any polarization selection functionality. Wavelength is only one degree of freedom. Polarization of the measurement illumination is another useful degree of freedom which may be exploited in metrology.

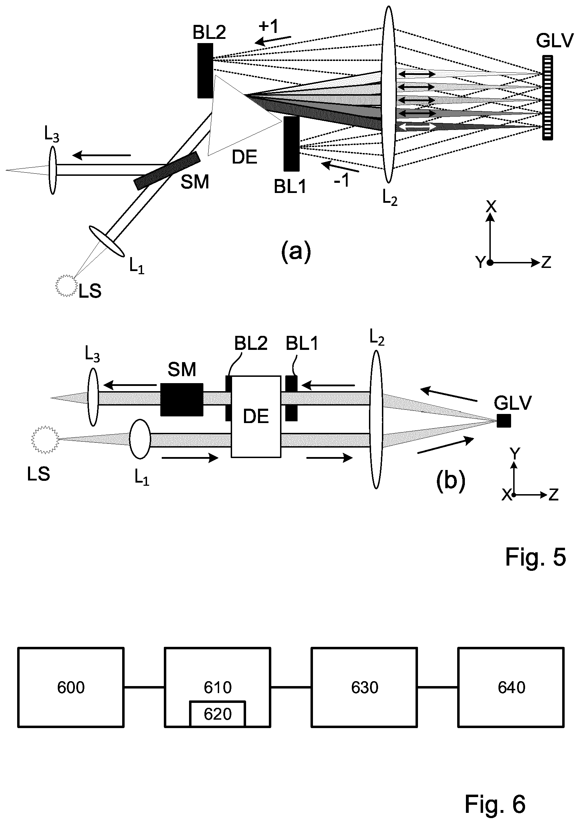

By way of example, and with reference to Figures 4 and 5, a GLV based illumination configuration module will now be described, configured to selectively transmit or block (diffract or reflect) at least part of incident broadband illumination. A GLV is an electrically-programmable diffraction grating based on Micro-Electro-Mechanical Systems (MEMS) technology. The GLV device may comprise configurable diffractive structures for selectively reflecting or diffracting the incident broadband illumination into an output radiation beam. Accordingly, output radiation illumination from such a module may comprise a spectrally configured beam having been modulated by the GLV device. A GLV device as used in embodiments disclosed herein may be a GLV device marketed by Silicon Light Machines (SLM), and/or based on GLV concept described in US6947613B, which is incorporated herein by reference.

Figures 4(a)-4(c) illustrate the working principal behind the GLV. Figures 4(a)-4(c) are schematic illustrations of a GLV pixel or component 500 from above and end-on, respectively. Please note that the GLV component shown in Figures 4(a)-4(c) is only an example design, other different GLV designs (e.g., the "true-GLV" design used in the G1088 and G8192 modules marketed by SLM) can also be used in any of the illumination configuration modules disclosed herein.

The GLV component comprises alternating GLV reflective ribbons of two types: static or bias ribbons 510 which are typically grounded along with a common electrode, and driven or active ribbons 520 which are driven by an electronic driver channel. A GLV device may comprise any number of these GLV components 500 arranged in an array (e.g., a 1D or 2D array). The active and bias ribbons may be essentially identical other than in how they are driven. In an embodiment, when no voltage is applied to the active ribbons 520, they are co-planar with the bias ribbons, a configuration illustrated in Figure 4(b). In this configuration, the GLV acts essentially as a mirror, with incident light being specularly reflected (i.e., forming specularly reflected radiation or zeroth diffraction order radiation). When a voltage is applied to the active ribbons 520, as illustrated in Figure 4(c), they deflect relative to the bias ribbons 510, establishing a square-well diffraction grating. In this state, incident light is diffracted into fixed diffraction angles. The ratio of light reflected with respect to light diffracted can be continuously varied by controlling the voltage on the active ribbons 520, which controls the magnitude of their deflection. As such, the amount of light diffracted by the GLV can be controlled in an analog fashion from zero (full specular reflection) to all incident light (zero specular reflection). This control of the amount of reflected radiation with respect to the amount of radiation diffracted into nonzero diffraction orders may be referred to as modulating the illumination within the context of this disclosure.

The GLV device may be used in a zeroth order mode such that the diffracted radiation is blocked/dumped and the specularly reflected (zeroth diffraction order) radiation is selected (e.g., transmitted into an output illumination beam). This has the advantage of preserving etendue. As such, an aperture stop may be provided in a pupil plane with the aim of maximizing transmission of the zeroth order, and maximizing blocking (minimizing transmission) of the first orders (and other diffraction orders). However, it can be appreciated that this may be reversed (i.e., operated in a first order mode), such that the specular radiation is dumped and diffracted radiation is transmitted to the output. This arrangement may have other advantages such as improved out of band suppression.

Figures 5(a) and 5(b) schematically illustrate a known illumination configuration module from two different viewpoints. A broadband optical beam emitted from a broadband light source LS is dispersed in the X direction by a beam dispersion element DE, which may comprise, for example, a prism or a grating. The dispersion of the broadband optical beam is achieved based on the principle that the direction of the light emerging from the beam dispersion element DE is wavelength dependent. The broadband optical beam may be optionally collimated by a first optical lens L1 before being dispersed by the beam dispersion element DE. The dispersed broadband optical beam may then be focused (e.g., by a second optical lens L2) onto the ribbons of the GLV device which is located substantially at the focal plane of the second lens L2. The different shading is indicative of different wavelengths of the dispersed radiation.

The GLV device may be configured in a zeroth order mode and is operable to apply a certain spatial modulation to the focused broadband optical beam so as to selectively reflect desired wavelengths and diffract away undesired wavelengths. In some embodiments, the GLV device may be operated in a wavelength selection mode to completely select one or more chosen wavelengths (e.g., without significant attenuation), and completely block the non-selected wavelengths. That is to say, the ribbons of the GLV device that correspond to the selected wavelengths may be set to equal heights such that they act like a standard mirror for the selected wavelengths and the other ribbons are actuated in such a way that they form a grating diffracting the undesired wavelengths into higher diffraction orders, e.g., -1st and +1st diffraction orders. These higher diffraction orders are then blocked or dumped by the beam blocks BL1, BL2, respectively. The GLV device may be operated also in intermediate modes or spectral shaping modes, e.g., to form a grating which partially reflects and partially diffracts the incident radiation for one or more wavelengths so as to attenuate but not completely block these one or more wavelengths. The degree of attenuation may be controlled via the ribbon configuration (the offset of the active ribbons with respect to the static ribbons). In this way, the spectral shape/constitution of the output radiation can be dynamically controlled.

The spatially modulated reflected (zeroth order) radiation from the GLV device may be captured by the second optical lens L2. The spatially modulated optical beam is recombined on a return path, e.g., using the same dispersion element DE as was used to disperse the beam on the outward path (alternatively separate dispersion elements can be used for dispersing and combining). The return path within the dispersion element DE may be substantially parallel with and displaced in the Y direction with respect to the outward path. The recombined output illumination beam may then be directed by the steering mirror SM towards, for example, a third optical lens L3. This third optical lens L3 may act as an output lens so as to focus the optical beam into a metrology device; e.g., via a suitable optical fiber such as a single mode photonic crystal fiber.

The concepts disclosed herein may relate to any metrology device such as a scatterometer as illustrated in Figure 3, or other metrology device such as an alignment sensor or level sensor described in relation to Figure 1, for example. Such devices may comprise a color selection module or illumination configuration module which enables configuration of the illumination spectrum (e.g., selection of one or more colors and/or their respective relative intensities) based on a broadband illumination source. The GLV device illustrated in Figure 5 (or a similar device configured in a first order mode implementation) may be used as the illumination configuration module for the embodiments disclosed herein. However this can be appreciated as being purely exemplary and any suitable device for spectral configuration/color selection may be used which is capable of relative attenuation of different wavelengths. Other devices (e.g., non-GLV based devices) may use other modulation devices (e.g., a spatial light modulator, acousto-optic modulator AOM, electro-optic modulator EOM or similar) in place of the GLV to modulate a dispersed beam. In other embodiments, the illumination configuration module may comprise a plurality of spectral filters (or one or more continuously variable spectral filters) which can be (individually and/or in different combinations) switched into the beam path (or selected portions switched into the beam path) to spectrally configure the illumination.

Figure 6 is a module diagram depicting the major modules of a metrology device at a high level. A source 600 generates a broadband illumination beam. An illumination configuration module 610 configures the illumination beam spectrum to obtain spectrally configured measurement illumination. For monitoring and control of the illumination configuration module 610, the illumination configuration module 610 may comprise a spectrometer 620 (or else a spectrometer may be located between illumination configuration module 610 and projection optical system 630). The spectrometer may measure the spectrum of at least a portion of the spectrally configured measurement illumination prior to projection by a projection optical system 630. The projection optical system 630 may be used to illuminate a wafer portion (e.g., comprising a structure or target) with the spectrally configured measurement illumination. The scattered, reflected and/or diffracted illumination from the wafer is then detected on a detector 640 (e.g., a camera). In many metrology tools, such as the metrology tool described in Figure 3, the detector 640 is capable of detecting only a signal amplitude metric such as intensity of the scattered radiation, and has no functionality for measuring its spectral characteristics.

The projection optical system of a metrology tool will typically have non-uniform spectral transmission characteristics, e.g., due to chromatic aberration and/or other effects. As a consequence of this, the spectrum seen by the detector is not necessarily the same as that set by the illumination configuration module. Additionally, respective projection optical systems of different metrology tools will typically have different spectral transmission characteristic. Therefore, the measurement illumination at wafer level (i.e., used for the actual measurement) may have significant tool-to-tool spectral variation for the same illumination setting at the illumination configuration module.

In a system where the spectrum can be specified fully in terms of a central wavelength and associated bandwidth, such tool-to-tool spectral variations will manifest as a dose difference, resulting in an integration time and/or signal level difference across different tools.

In a system where a full spectrum is set, spectral transmission variation will manifest itself in poor tool-to-tool matching. Figure 7 illustrates this in a simple two color λ1, λ2 example. Figure 7(a) shows is a spectrum plot (intensity I against wavelength λ) for the spectrally configured measurement illumination immediately after the illumination configuration module (i.e., before the projection optical system), for each of two different metrology tools MET1, MET2. Two color bands λ1, λ2 of equal intensity have been selected by each illumination configuration module of the two metrology tools MET1, MET2, with the selected spectra for each tool being the same.

Figure 7(b) are spectrum plots describing the effect of the respective spectral transmission characteristics of the two metrology tools MET1, MET2 on the set spectra of Figure 7(a). In this simplified example, each color λ1, λ2 of the first metrology tool MET1 are attenuated equally by a small amount, while there is a large disparity in the attenuation of the two colors λ1, λ2 for the second tool MET2, with color λ1 being attenuated more than color λ2. The spectral transmission variations have been exaggerated for illustration.

Figure 7(c) are spectrum plots of the respective configured measurement illumination at wafer level. Naturally, these are the same as the plots of Figure 7(b). It should again be appreciated that this spectral information is typically unavailable at the detector, the detector will simply measure a single intensity for all colors combined.

To address this issue, a method is proposed for spectrally configuring measurement illumination of a metrology tool, e.g., using an illumination configuration module of the metrology tool, before a projection optical system of the metrology tool, so as to obtain a desired spectral shape (e.g., per wavelength) of the metrology tool. Such a method may comprise: a) projecting measurement radiation using said projection optical system to obtain projected measurement radiation, b) measuring a signal amplitude metric (e.g., any metric related to signal amplitude such as signal amplitude, intensity or power) of said projected measurement radiation at a detector; c) determining a spectral shape of the projected measurement radiation from the signal amplitude metric; and d) spectrally configuring the measurement illumination before the projection optical system to adjust said spectral shape to match a desired spectral shape.

Said spectrally configuring the measurement illumination may compensate for spectral transmission characteristics of the projection optical system. The method may be performed for at least a first metrology tool and a second metrology tool, such that a first spectral shape of the measurement illumination of the first metrology tool and a second spectral shape of the measurement illumination of the second metrology tool are matched for a common desired measurement illumination setting using the first metrology tool and second metrology tool. A desired illumination setting may be as defined by a measurement recipe for a particular measurement, for example.

The method may comprise determining the spectral transmission characteristics of the projection optical system of the first metrology tool (e.g., a reference metrology apparatus); and determining said desired spectral shape for the second metrology tool (and other metrology tools) from the determined spectral transmission characteristics of the projection optical system of the first metrology tool. For example, the method may comprise: performing steps a) to c) for the first metrology tool to determine the spectral shape imposed by the spectral transmission characteristics of the projection optical system of the first metrology tool; and performing steps a) to d) for a second metrology tool, wherein said desired spectral shape is the determined spectral shape imposed by the first metrology tool.

The spectral shape may be determined using no device downstream of said projection optical system which comprises spectral measurement capability/functionality.

In the context herein, a matched spectral shape may be obtained when the respective spectral shapes of the projected measurement radiation are matched. This may be the case when the relative intensity variation per wavelength within each spectrum is matched to that of a desired spectrum (e.g., spectrum of another tool), such that there may be only a global intensity or signal magnitude difference between the spectra. Of course, the spectral matching may be considered matched should the spectral shape be sufficiently similar (e.g., substantially similar), e.g., according to matching threshold, rather than identical.

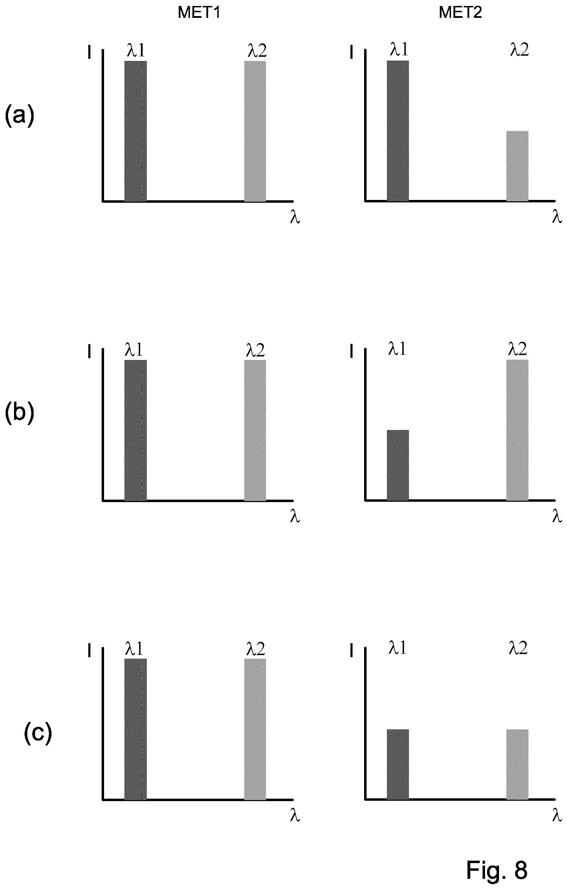

Figure 8 illustrates the proposed method according to an embodiment. In this example, the two metrology tools MET1, MET2 are the same as those of Figure 7, having the same spectral transmission characteristics (i.e., Figure 8(b) is the same as Figure 7(b)). The desired spectral shape in this example is flat over the two selected wavelength bands (i.e., color λ1 and color λ2 have equal relative intensity). This desired shape may be as dictated by the spectral response of a reference metrology tool (e.g., metrology tool MET2 may be being matched to reference metrology tool MET1 in this example), and/or may be a desired spectral shape of which one or more tools are being matched to (e.g., the spectral shapes of metrology tool MET1 and metrology tool MET2 are both being matched to have this desired spectral shape).

In any case, this desired spectral shape, as described by Figure 8(c), may be obtained by changing/adjusting the spectrally configured measurement illumination via the illumination configuration module for the second metrology device to compensate the relative attenuation differences seen by the two wavelengths. Of course, it is not possible to increase the intensity of color λ1 (or any color) using the illumination configuration module, so instead the relative intensity of color λ2 may be attenuated with respect to that of color λ1 in metrology tool MET2.

In this manner, the spectral content at color selection is adapted to reflect the spectral transmission of the metrology tools.

To measure the spectral shape of the measurement illumination at wafer level, it is proposed to define a spectral line (e.g., a narrow bandwidth range) and vary its color (e.g., sweep over a wavelength range of interest) using the illumination configuration module while measuring the signal amplitude metric at the detector and the corresponding spectrometer signal (e.g., in terms of central wavelength and bandwidth) of the spectrometer (e.g., as comprised within the illumination configuration module). The measured spectral shape can be determined from the shape of the signal amplitude metric at the detector over time combined with the spectral information from the spectrometer signal such that the time information can be substituted with the temporally corresponding spectral information. This may be done for all metrology tools that are to be matched. The intensity of the line may be maintained constant during the sweep, thereby ensuring that any intensity variation at the detector is dependent substantially only on the spectral characteristics of the projection optical system. However, this is not essential and the intensity may be varied during the sweep (e.g., the detector reading may be correlated with known intensity variation of the line).

It can be appreciated that measuring the signal amplitude metric at the detector may be done with a wafer or other object on a substrate support of the metrology tool such that the wafer scatters (e.g., reflects and/or diffracts) the measurement illumination to the detector.

While the simplified example described in Figure 8 relates to only two wavelengths, the concepts described can of course be applied to any spectrum including a continuous spectrum or larger plurality of discrete wavelength bands.

As can be seen, while the spectral shape may be matched, the overall intensity of the measurement illumination may be different between the matched tools. This can be addressed for example by varying the measurement times per tool to match the effective intensities on the detector (i.e., to use longer measurement times for the tool with lower measurement illumination intensity). Alternatively or in addition, the measurement illumination intensity may be varied or increased such that intensity is optimized (e.g., maximized) for at least one wavelength.

Although specific reference may have been made above to the use of embodiments of the invention in the context of optical lithography, it will be appreciated that the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

The terms "radiation" and "beam" used herein encompass all types of electromagnetic radiation, including ultraviolet (UV) radiation (e.g., having a wavelength of or about 365, 355, 248, 193, 157 or 126 nm) and extreme ultra-violet (EUV) radiation (e.g., having a wavelength in the range of 5-20 nm), as well as particle beams, such as ion beams or electron beams.

The term "lens", where the context allows, may refer to any one or combination of various types of optical components, including refractive, reflective, magnetic, electromagnetic and electrostatic optical components.

The foregoing description of the specific embodiments will so fully reveal the general nature of the invention that others can, by applying knowledge within the skill of the art, readily modify and/or adapt for various applications such specific embodiments, without undue experimentation, without departing from the general concept of the present invention. Therefore, such adaptations and modifications are intended to be within the meaning and range of equivalents of the disclosed embodiments, based on the teaching and guidance presented herein. It is to be understood that the phraseology or terminology herein is for the purpose of description by example, and not of limitation, such that the terminology or phraseology of the present specification is to be interpreted by the skilled artisan in light of the teachings and guidance.

The breadth and scope of the present invention should not be limited by any of the above-described exemplary embodiments, but should be defined only in accordance with the following claims and their equivalents.

## Claims

1. A method of spectrally configuring measurement illumination of a metrology tool, the method comprising:
a) projecting measurement radiation using said projection optical system to obtain projected measurement radiation;
b) measuring a signal amplitude metric of said projected measurement radiation at a detector;
c) determining a spectral shape of the projected measurement radiation from the signal amplitude metric; and
d) spectrally configuring the measurement illumination before the projection optical system to adjust said spectral shape to match a desired spectral shape.

2. A method as claimed in claim 1, wherein said spectrally configuring the measurement illumination compensates for spectral transmission characteristics of the projection optical system.

3. A method as claimed in claim 1 or 2, comprising performing said method or at least a subset of steps thereof for each of at least a first metrology tool and a second metrology tool, such that a first spectral shape of the measurement illumination of the first metrology tool and a second spectral shape of the measurement illumination of the second metrology tool are matched to obtain a common desired measurement illumination setting using the first metrology tool and second metrology tool.

4. A method as claimed in claim 3, comprising:
determining the spectral transmission characteristics of the projection optical system of the first metrology tool; and
determining said desired spectral shape for the second metrology tool from the determined spectral transmission characteristics of the projection optical system of the first metrology tool.

5. A method as claimed in claim 3 or 4, wherein the method comprises:
performing steps a) to c) for the first metrology tool to determine the spectral shape imposed by the spectral transmission characteristics of the projection optical system of the first metrology tool; and
performing steps a) to d) for a second metrology tool, wherein said desired spectral shape is the determined spectral shape imposed by the first metrology tool.

6. A method as claimed in any of claims 3 to 5, comprising determining a measurement time difference between a measurement time using the first metrology tool and a measurement time using the second metrology tool which compensates for an intensity difference of measurement illumination or spectrally configured measurement illumination for the first metrology tool and the spectrally configured measurement illumination of step d) for the second metrology tool.

7. A method as claimed in any preceding claim, comprising varying an intensity of the measurement illumination such that intensity of the spectrally configured measurement illumination of step d) is optimized and/or maximized for at least one wavelength.

8. A method as claimed in any preceding claim, wherein said signal amplitude metric is measured using a detector comprising no spectral measurement capability.

9. A method as claimed in any preceding claim, wherein step c) comprises:
spectrally configuring the measurement illumination to define a spectral line;
varying the wavelength of the spectral line over a wavelength range of interest;
measuring the signal amplitude metric at the detector and a corresponding spectrometer signal relating to the spectrum of said spectral line at a location before said projection optical system; and
determining said spectral shape form the signal amplitude metric and spectrometer signal.

10. A method as claimed in any preceding claim, comprising performing a measurement with the spectrally configured measurement illumination of step d).

11. A method as claimed in any preceding claim, wherein said signal amplitude metric comprises one or more of: signal amplitude, signal intensity or signal power.

12. At least one metrology device operable to perform the method of any of claims 1 to 11.

13. At least one metrology device as claimed in claim 12, each said at least one metrology device comprising:
an illumination configuration module for spectrally configuring measurement radiation to obtain spectrally configured measurement radiation;
a projection optical system for projecting the spectrally configured measurement radiation onto as substrate; and
a substrate support for supporting the substrate.

14. At least one metrology device as claimed in claim 13, wherein the illumination configuration module comprises a grating light valve device.
